Europäisches Patentamt

European Patent Office

Office européen des brevets

(11) Veröffentlichungsnummer: **0 630 129 A2**

# (12) EUROPÄISCHE PATENTANMELDUNG

(21) Anmeldenummer: **94107896.6**

(22) Anmeldetag: **21.05.94**

(51) Int. Cl.⁵: **H04L 7/033**, H03L 7/197

(30) Priorität: **09.06.93 DE 4319066**
**09.06.93 US 74108**

(43) Veröffentlichungstag der Anmeldung:
**21.12.94 Patentblatt 94/51**

(84) Benannte Vertragsstaaten:
**AT BE CH DE ES FR GB IT LI NL SE**

(71) Anmelder: **Alcatel SEL Aktiengesellschaft**
**Lorenzstrasse 10**
**D-70435 Stuttgart (DE)**

(72) Erfinder: **Rieder, Klaus-Hartwig**
**Mittlerer Bauernwaldweg 9**
**D-70195 Stuttgart (DE)**
Erfinder: **Hörsch, Günter**
**Heuweg 21**
**D-71263 Weil der Stadt (DE)**
Erfinder: **Powell, William Edward**
**201 Trotters Ridge Drive**
**Raleigh,**
**North Carolina 27614 (US)**
Erfinder: **Ledda, Francesco**
**2628 Teakwood Lane**
**Plano,**
**Texas 75075 (US)**

(74) Vertreter: **Müller, Joachim et al**
**Alcatel SEL AG,**
**Patent- und Lizenzwesen,**
**Postfach 300 929**
**D-70449 Stuttgart (DE)**

(54) Verfahren zur Erzeugung eines synchronisierten Taktes mit einer Schaltungsanordnung für einen regelbaren Oszillator.

(57) Um eine störungsfreie Übertragung digitaler Nachrichten zu gewährleisten, werden Oszillatoren mit hoher Güte und Zuverlässigkeit bei langer Lebensdauer benötigt. Für diese Zwecke werden spannungsgesteuerte Oszillatoren eingesetzt, die über einen Mikroprozessor und einen Digital/Analogwandler abgestimmt werden und Bestandteil eines Phasenregelkreises sind. Bei diesen Anordnungen muß ein Kompromiß zwischen Regelbereich und Stabilität gefunden werden, die Regelkennlinie ist nichtlinear und die Auflösung ist durch die Schrittweite des Digital/Analogwandlers begrenzt. In dem erfindungsgemäßen Verfahren und der dabei eingesetzten Schaltungsanordnung wird ein Oszillator angegeben, dessen Frequenz linear in einem großen Regelbereich verändert werden kann, ohne daß die Stabilität des Oszillators beeinflußt wird. Die Schaltung wird mit einer üblichen 5-V-Betriebsspannung versorgt. Dazu wird die Frequenz eines Festfrequenzgenerators (1) mit einem Frequenzteiler (2), dessen Teilerverhältnis in sehr kleinen Schritten variiert werden kann, auf die gewünschte Frequenz geteilt und der dabei entstehende Jitter wird mit einem einfachen Phasenregelkreis (3) gefiltert. Der Oszillator ist universell als Taktgenerator in allen digitalen Schaltungsanordnungen einsetzbar.

Fig. 1

Die Erfindung betrifft ein Verfahren zur Erzeugung eines synchronisierten Taktes mit einer Schaltungsanordnung für einen regelbaren Oszillator, der beispielsweise Basis für Taktgeneratoren in digitalen Nachrichtenübertragungssystemen ist. Um eine störungsfreie Übertragung digitaler Nachrichten zu gewährleisten, werden Oszillatoren mit hoher Güte und Zuverlässigkeit bei langer Lebensdauer benötigt. Es ist allgemein bekannt, für diese Zwecke spannungsgesteuerte Quarzoszillatoren einzusetzen, die über einen Mikroprozessor und einen Digital/Analogwandler abgestimmt werden und Bestandteil eines Phasenregelkreises sind, vgl. Ernst, W., Hartmann H.L.: Neue Taktgeneratoren für EWSD. telecom report 9 (1986) Heft 4, S. 263-269. Um die hohen Anforderungen an die Genauigkeit und Stabilität eines Taktgenerators zu erfüllen, ist ein beträchtlicher Schaltungsaufwand erforderlich, beispielsweise werden mikroprozessorgesteuerte digitale Phasenregelkreise eingesetzt. Dennoch setzen die physikalischen Eigenschaften eines regelbaren Quarzoszillators bestimmte Grenzen. So muß stets ein Kompromiß zwischen Regelbereich und Stabilität gefunden werden, weil mit Vergrößerung des Regelbereichs die Stabilität des Quarzoszillators abnimmt, somit ist der Regelbereich begrenzt. Wegen der Nichtlinearität der Regelkennlinie, die die Funktion der Frequenz von der Steuerspannung beschreibt, müssen Toleranzen der Steilheit der Regelkennlinie von ± 50 % bei der Dimensionierung der Schaltung berücksichtigt werden. So muß der Phasenregelkreis für eine Verstärkungsschwankung von ± 50 % beziehungsweise mit einer Bandbreitetoleranz von ± 50 % ausgelegt sein. Schließlich ist die Auflösung des Regelbereichs durch die Schrittweite des Digital/Analogwandlers begrenzt, wobei Temperaturänderungen und Nichtlinearitäten zusätzliche Einflußgrößen auf die Arbeitsweise des Digital/Analogwandlers sind. Überlicherweise müssen Digital/Analogwandler mit Betriebsspannungen von mindestens ± 12 V versorgt werden. Bei abstimmbaren thermostatgeregelten Quarzoszillatoren sind die geringe Langzeitstabilität, die Temperaturabhängigkeit und die Nichtlinearität der Regelkennlinie Eigenschaften, aus denen Probleme bei der Realisierung von hochgenauen Taktgeneratoren resultieren.

Aufgabe der Erfindung ist es nun, einen kostengünstigen und universell einsetzbaren Oszillator anzugeben, der unter Einhaltung enger Toleranzen im wesentlichen kontinuierlich über einen großen Bereich geregelt werden kann, ohne daß dadurch die Stabilität beeinflußt wird. Die Stromversorgung soll ausschließlich von einer Standard-5-V-Spannungsquelle erfolgen. Mit dem Einsatz eines solchen Oszillators soll ein Verfahren angegeben werden, bei dem durch mikroprozessorgesteuerte Baugruppen und mit einem kostengünstigen Phasenregelkreis Taktfrequenzen in einem großen Frequenzbereich mit hoher Genauigkeit erzeugt werden können.

Diese Aufgabe wird durch die im ersten Anspruch beschriebene Schaltungsanordnung und das im sechsten Anspruch beschriebene Verfahren gelöst. In den Ansprüchen zwei bis fünf sind Realisierungsvarianten der Schaltungsanordnung angegeben, die sich durch die interne Frequenzaufbereitung unterscheiden. Die Ansprüche sieben bis zehn geben Verfahrensabläufe in unterschiedlichen Varianten einer PLL-Schaltung bei Einsatz der erfindungsgemäßen Schaltungsanordnung wieder.

Das Wesen der Erfindung besteht darin, daß die gewünschte Frequenz von einem thermostatgeregelten Standard-Festfrequenzoszillator im wesentlichen über einen Frequenzteiler, dessen Teilerverhältnis in beliebigen Schritten verändert werden kann, abgeleitet wird. Der Einsatz eines Digital/Analogwandlers entfällt, so daß vorteilhafterweise der Taktgenerator mit einer üblichen 5-V-Betriebsspannung versorgt werden kann. Mit der erfindungsgemäßen Schaltungsanordnung kann die Frequenz linear in einem Regelbereich von ± 70 ppm (parts per million) verändert werden, ohne daß dadurch die Stabilität des Oszillators überhaupt beeinflußt wird. Die Alterung des Festfrequenzoszillators kann daher problemlos kompensiert werden.

Einzelheiten der Erfindung werden nachstehend in Ausführungsbeispielen erläutert. In der dazugehörigen Zeichnung zeigen

Fig. 1    ein Blockschaltbild der erfindungsgemäßen Schaltungsanordnung,

Fig. 2    eine erste Schaltungsvariante mit einem Detailschaltbild eines Analog-Phasenregelkreises,

Fig. 3    eine zweite Schaltungsvariante der erfindungsgemäßen Schaltungsanordnung,

Fig. 4    eine dritte Schaltungsvariante der erfindungsgemäßen Schaltungsanordnung,

Fig. 5    eine vierte Schaltungsvariante mit zwei Impulsausblendschaltungen,

Fig. 6    eine Schaltungsanordnung einer schmalbandigen PLL-Schaltung, die die erfindungsgemäße Schaltungsanordnung eines regelbaren Oszillators enthält,

Fig. 7    eine Schaltungsanordnung für einen in Fig. 6 enthaltenen digitalen Frequenzsynthesizer und

Fig. 8    eine Schaltungsanordnung für eine Variante eines digitalen Frequenzsynthesizers mit abschaltbarer Impulsausblendschaltung.

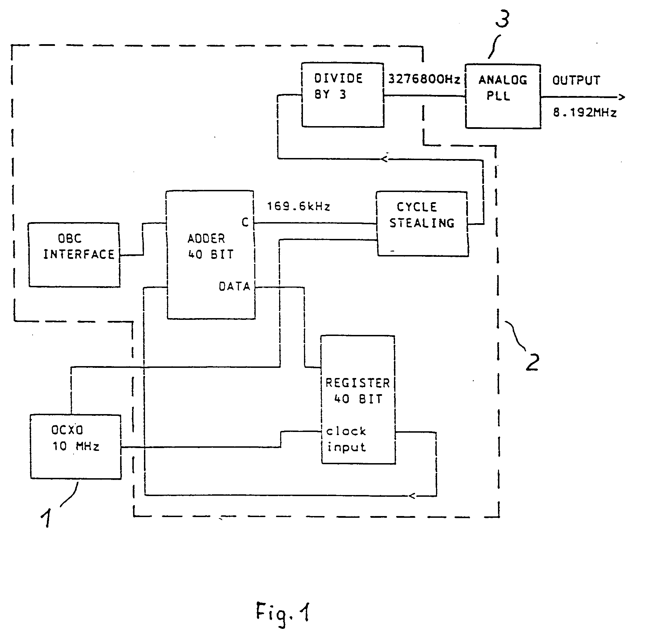

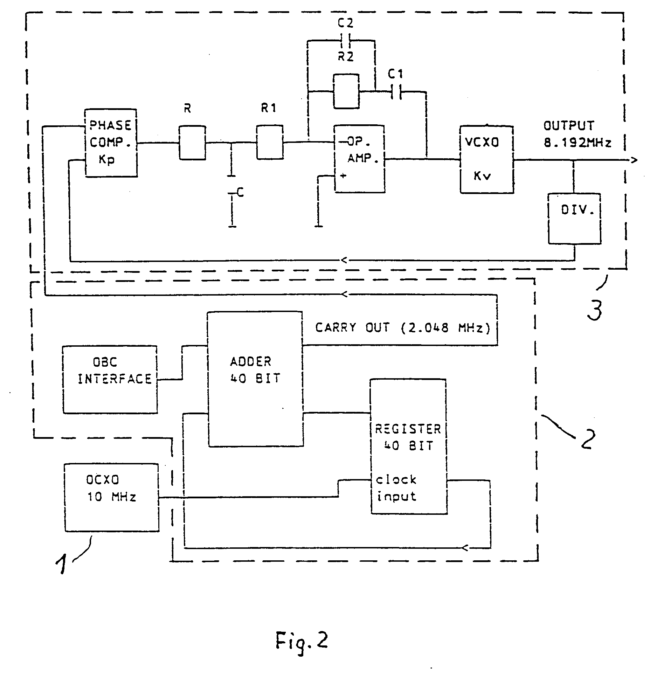

Gemäß Fig. 1 besteht die Schaltungsanordnung für einen regelbaren Oszillator aus einem thermostatstabilisierten Festfrequenzgenerator 1, engl. Oven Controlled Crystal Oscillator OCXO, einem Frequenzteiler 2 mit variablem Teilerverhältnis und einem analogen Phasenregelkreis 3, engl. Phase-Locked Loop PLL. Der Frequenzteiler 2 besteht im wesentlichen aus einem Register und einem Addierer, engl. Adder, der über eine Schnittstellenschaltung, engl. On Board Controller Interface OBC, von einem Mikroprozessor angesteuert wird, sowie bedarfsweise aus Impulsausblendschaltungen, engl. Cycle Stealing, und Frequenzteilern mit festem Teilerverhältnis, hier beispielsweise Divide by 3. Der analoge Phasenregelkreis 3 besteht gemäß Fig. 2 aus einem Phasendetektor Phase Comp., einem aktiven Schleifenfilter mit einem Operationsverstärker Op. Amp. und einem spannungsgesteuerten Oszillator VCXO, engl. Voltage Controlled Crystal Oscillator, sowie bedarfsweise aus einem Frequenzteiler DIV, über den die Referenzfrequenz für den Phasendetektor Phase Comp. bereitgestellt wird. Der analoge Phasenregelkreis 3 wird vorteilhafterweise wie folgt dimensioniert

| R = 10 000 Ohm | C = 15,9 nF |
| R1 = 872 340 Ohm | C1 = 75 nF |
| R2 = 1000 000 Ohm | C2 = 159 pF |

Die Steilheit des Phasenkomperators beträgt Kp = 0,4V/rad. Die Regelsteilheit des spannungsgesteuerten Oszillators VCXO beträgt Kv = 204,8 Hz/V. Daraus ergibt sich eine Bandbreite des analogen Phasenregelkreises von annähernd 90 Hz.

Bei der in Fig. 1 dargestellten Schaltungsanordnung taktet der Festfrequenzgenerator 1 das Register, dessen Inhalt in dem Addierer zu einem von dem Mikroprozessor OBC gelieferten digitalen Stellwert addiert wird. Am Carry-Ausgang des Addierers entsteht dann eine Impulsfolge, deren Frequenz durch den digitalen Stellwert des Mikroprozessors OBC variiert werden kann. Bei Vergrößerung des digitalen Stellwerts und gleichbleibender Frequenz des Festfrequenzgenerators 1 wird die Frequenz am Carry-Ausgang erhöht. Somit ist eine Frequenzvariation in sehr kleinen Stufen möglich. Die erzeugte Frequenz f wird aus dem digitalen Stellwert m und der Bitbreite des Addierers n nach folgender Beziehung errechnet:

$$f = f_{OCXO} \cdot \left( \frac{m}{2^n} \right)$$

Mit einer Impulsausblendschaltung wird mittels sogenanntem Cycle Stealing von der Frequenz f1 = 10 MHz des Festfrequenzgenerators die Ausgangsfrequenz f2 = 169,6 kHz des Addierers subtrahiert. Das Ergebnis f3 = 9,8304 MHz wird von einem Frequenzteiler durch drei dividiert und dem analogen Phasenregelkreis 3 zugeführt. Der analoge Phasenregelkreis 3 wird in der erfindungsgemäßen Schaltung nicht wie im bekannten Stand der Technik als frequenzbestimmende Baugruppe des Taktgenerators eingesetzt, sondern dient zur Filterung des durch die Impulsausblendung entstandenen Jitters und zur Frequenzvervielfachung. Durch die digitale Frequenzaufbereitung ist ein Jitter bedingt, der jedoch durch den analogen Phasenregelkreis 3 einfachster Bauart mit einem herkömmlichen Quarzoszillator in engen Grenzen gehalten wird. Für die in Fig. 1 dargestellte Schaltung und mit der oben genannten Dimensionierung des analogen Phasenregelkreises 3 wird bei der Ausgangsfrequenz f4 = 8,192 MHz ein Jitter von weniger als 280 Picosekunden innerhalb eines Regelbereiches von ± 7 ppm erreicht. Die Frequenzauflösung oder Schrittweite beträgt in der dargestellten Dimensionierung

$$\frac{\Delta f}{f} = 9,25 \cdot 10^{-13} \, .$$

Für viele Anwendungsfälle ist die in Fig. 2 dargestellte Schaltungsanordnung, bei der im Vergleich zu der in Fig. 1 dargestellten Schaltung auf die Impulsausblendschaltung mit nachgeschaltetem Frequenzteiler verzichtet wird, ausreichend. Bei dieser einfachen und universellen Lösung entsteht bei der angegebenen Dimensionierung ein Jitter von weniger als 800 Picosekunden.

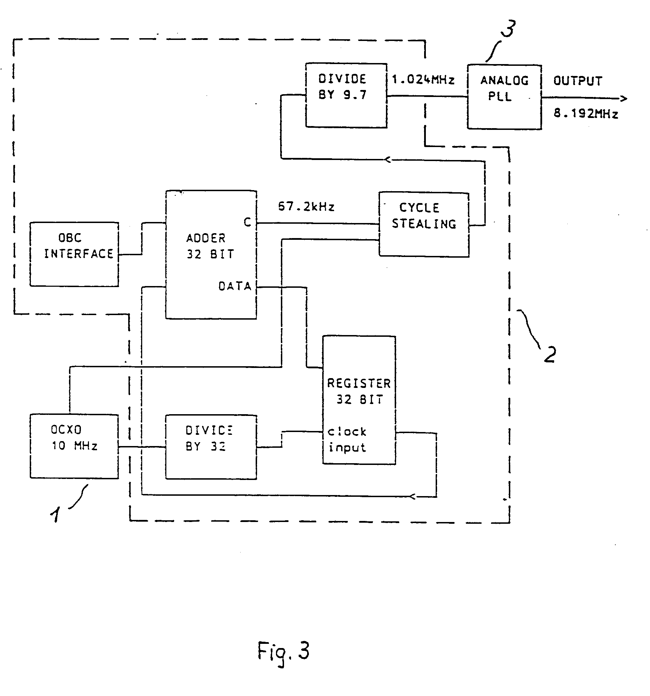

In Fig. 3, Fig. 4 und Fig. 5 sind Varianten der erfindungsgemäßen Schaltungsanordnung dargestellt, die sich in der Art der Frequenzaufbereitung unterscheiden und je nach Ausgangsfrequenz und zugelassenem Jitter vorteilhaft sind.

Gemäß Fig. 3 wird die Frequenz f1 = 10 MHz des Festfrequenzgenerators 1 zunächst von einem Frequenzteiler durch 32 dividiert bevor die Weiterverarbeitung mit gleicher Schaltungsstruktur wie in Fig. 1 dargestellt erfolgt. Diese Schaltung hat den Vorteil, daß die Bitbreite von Register und Addierer nur 32 Bit beträgt, um eine vergleichbare Einstellgenauigkeit zu erreichen.

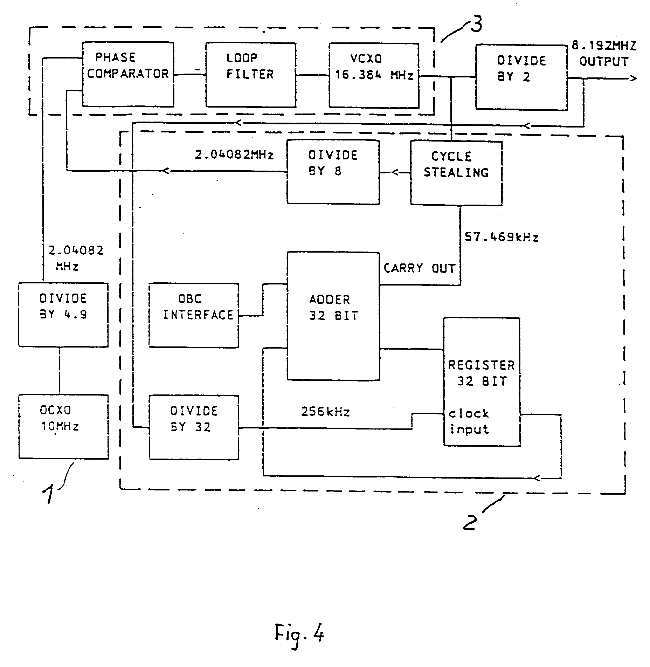

Fig. 4 zeigt eine Schaltungsanordnung, bei der die Frequenz f1 = 10 MHz des Festfrequenzgenerators 1 auf eine Frequenz f = 2,04082 MHz geteilt und dann als Sollfrequenz dem Phasendetektor zugeführt wird. Die Vergleichsfrequenz wird durch Cycle Stealing aus der Differenz der Frequenz der Ausgangsimpulse des analogen Phasenregelkreises 3 und der Ausgangsfrequenz des Addierers über einen der Impulsausblendschaltung nachgeschaltetem Frequenzteiler gebildet. Eine solche Schaltungsanordnung ist dann zweckmäßig, wenn Frequenzen erzeugt werden sollen, bei denen der Jitter im Vergleich zu' den zuvor genannten Schaltungsanordnungen geringer ist.

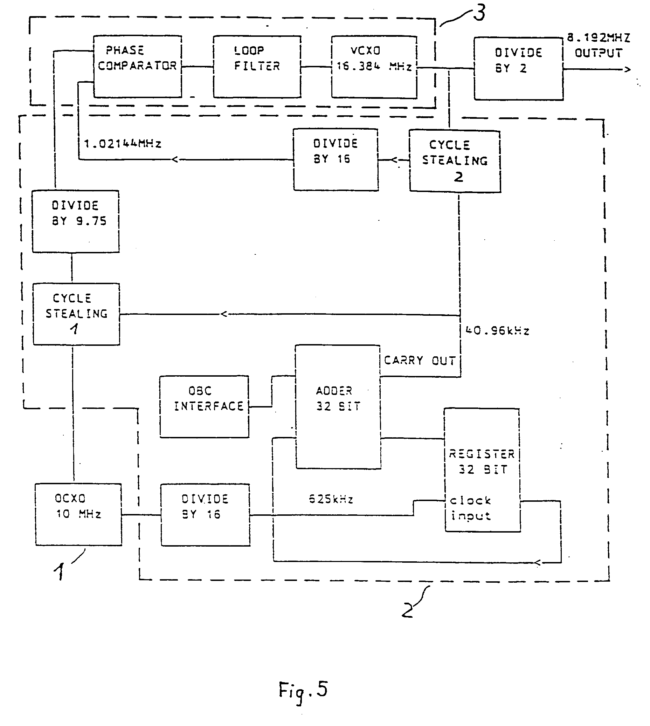

In Fig. 5 ist eine Schaltungsvariante dargestellt, bei der sowohl die Sollfrequenz als auch die Vergleichsfrequenz für den Phasendetektor des analogen Phasenregelkreises 3 mittels Impulsausblendschaltungen aus Frequenzdifferenzen gebildet werden. Die grundsätzliche Schaltungsstruktur bleibt jedoch erhalten. Die Schaltungsvariante ist besonders dann günstig, wenn Frequenzen mit besonders niedrigem Jitter erzeugt werden sollen.

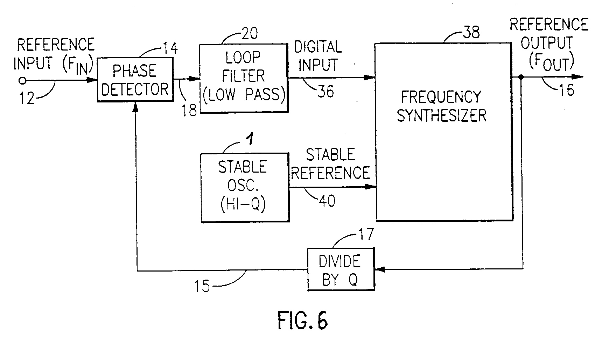

Fig. 6 zeigt die Schaltungsanordnung einer schmalbandigen PLL-Schaltung. Sie besteht im wesentlichen aus einem Festfrequenzgenerator 1, einem Phasendetektor 14, einem Schleifenfilter 20 und einem Frequenzsynthesizer 38, der den erfindungsgemäßen regelbaren Oszillator enthält, sowie bedarfsweise einen Frequenzteiler. Ein digitales Vergleichssignal am Eingang auf Leitung 12 mit einer Frequenz $F_{IN}$ und ein Signal auf Leitung 15, das das Teilungsergebnis des Ausgangssignals 16 mit einer Frequenz $F_{OUT}$ ist, werden beide einem Phasendetektor 14 zugeführt. Es ist ein Frequenzteiler 17 mit einem Teilerfaktor Q dargestellt, der das Ausgangssignal 16 auf eine niedrigere Frequenz

$$\frac{F_{IN}}{Q}$$

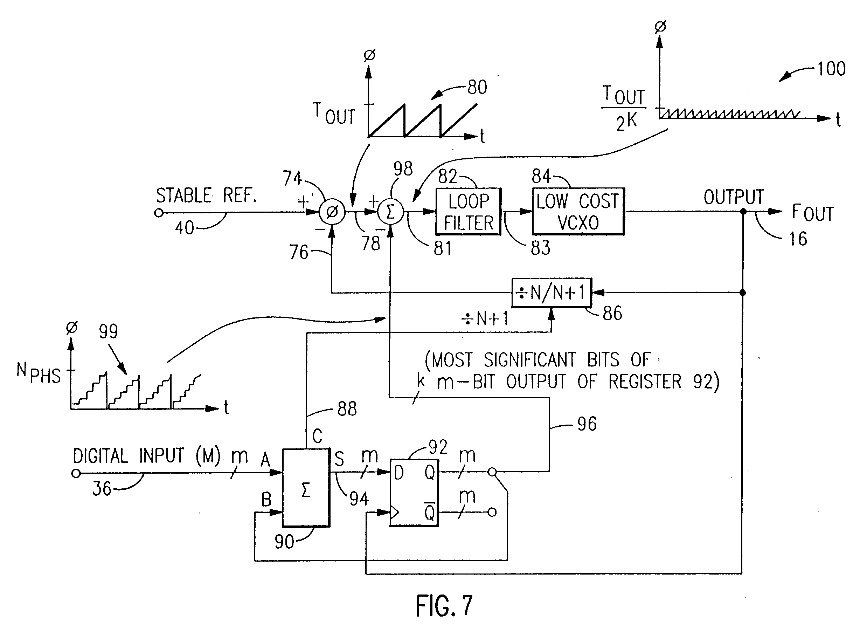

herunterteilt, damit sie mit dem Eingangssignal auf Leitung 12 in Übereinstimmung gebracht werden kann. Es ist auch möglich, den Frequenzteiler 17 wegzulassen, wenn die Frequenzen von Eingangs- und Ausgangssignal übereinstimmen. Das digitale Vergleichssignal am Eingang auf Leitung 12 mit einer bestimmten Frequenz kann von einem Netzwerk herrühren, während das Ausgangssignal auf Leitung 16 ein lokales Taktsignal sein kann, das mit dem digitalen Vergleichssignal am Eingang auf Leitung 12 synchronisiert werden muß. Die Synchronisierung ist erforderlich, um Signale in unterschiedliche Netzebenen übertragen zu können und um die lokalen Taktversorgungen zu den Takten im Netzwerk synchron zu halten. Der Phasendetektor 14 liefert ein Fehlersignal auf Leitung 18 an das Schleifenfilter 20, das die Hochfrequenzstörungen, wie beispielsweise Rauschen, filtert. Das Schleifenfilter 20 liefert ein digitales Fehlersignal auf Leitung 36 an den Frequenzsynthesizer 38, der ein hochstabiles Taktsignal auf Leitung 40 von dem Festfrequenzgenerator 1 erhält, der eine große Stabilität und eine hohe Güte hat. Der Aufbau des Frequenzsynthesizers 38 wird nachfolgend anhand Fig. 7 beschrieben. Der Frequenzsynthesizer 38 liefert das Ausgangssignal auf Leitung 16, das eine große Kurzzeitstabilität und einen großen Ziehbereich hat und eine sehr feingestufte Frequenzauflösung ermöglicht.

In Fig. 7 ist entsprechend der Realisierung der vorliegenden Erfindung ein Synthesizer mit beliebigem Teilverhältnis N dargestellt, der die Frequenzsynthese in einem großen Frequenzbereich mit hoher Auflösung ermöglicht und der von nur einer Quelle gesteuert wird. Fig. 7 zeigt Einzelheiten des in Fig. 6 dargestellten Frequenzsynthesizers 38. Eingangssignale sind das Signal auf Leitung 36 in Fig. 6, daß das Ausgangssignal des Filters 20 ist, und das Festfrequenzsignal auf Leitung 40. Der Ausgang des Festfrequenzgenerators auf Leitung 40 ist mit einem Phasendetektor 74 verbunden, an dem außerdem ein Rückkopplungssignal auf Leitung 76 liegt, um ein Fehlersignal auf Leitung 78 zu erzeugen, daß nach einer Zeitfunktion 80 verläuft, die als Phasenfehler in Abhängigkeit von der Zeit dargestellt ist. Die PLL-Schaltung in Fig. 7 enthält ein Schleifenfilter 82 und einen spannungsgesteuerten Oszillator 84 ebenso wie einen Teiler 86, der immer durch N teilt außer wenn ein carry-Signal auf Leitung 88 von einem Addierer 90 vorhanden ist. Dann wird das Ausgangssignal auf Leitung 16 durch N + 1 statt durch N geteilt.

Das Maß für das Anwachsen des Phasenfehlers oder der Anstieg der Sägezahnf lanken der Zeitfunktion 80 und die Sägezahnperiode hängen von der momentanen Differenz der Frequenzen und Phasen zwischen den Signalen auf den Leitungen 40 und 76 ab, die wiederum das Teilerverhältnis des Teilers 86 beeinflussen. In der Zeitfunktion 80 beschreiben die jeweiligen ansteigenden Sägezahnflanken Zeitabschnitte, in denen der Teiler 86 durch N teilt. Die Sägezahnspitze, bei der der Sägezahn seinen höchsten Wert erreicht und auf Null zurückspringt, beschreibt den Augenblick, in dem der Teiler 86 durch N + 1 teilt. Der Grund, die meiste Zeit durch N zu teilen und nur sehr kurze Zeit durch N + 1 zu teilen, besteht darin, die Ausgangsfrequenz auf Leitung 16 stufenlos zu teilen und den Quotienten der stufenlosen Division mit der Festfrequenz zu vergleichen. Abhängig von der Frequenz, mit der der Teiler 86 durch N + 1 teilt, wird die Ausgangsfrequenz der PLL-Schaltung mit feinstufiger Auflösung verändert, wobei das auch abhängig ist von der Festfrequenz auf Leitung 40.

Ein Phasenakkumulator besteht aus einem Addierer 90, der ein m-bit Eingang hat, an dem der digitale Eingang Leitung 36 liegt, und einer m-bit Ausgangsleitung 94, die an einem Register 92 liegt, das aus m Flipflops besteht. Die Auflösung des Phasenakkumulators kann sehr hoch gewählt werden, beispielsweise 40 bits. Der Registerstand wird in jeder Periode des Ausgangstaktes 16 mit dem Zählimpuls auf Leitung 36, der proportional der Ausgangsfrequenz auf Leitung 16 ist, vergrößert. Üblicherweise, wie bereits zuvor dargestellt, teilt der Teiler 86 in der Rückkopplungsschleife durch N. Wenn jedoch der Addierer 90 überläuft, wird das Teilerverhältnis zeitweise in N+1 geändert. Das bewirkt die sägezahnförmige Phasenfehler-Modulation des Signals auf Leitung 76 und als Folge des Signals auf Leitung 78 von dem Phasendetektor 76, die kompensiert werden muß. Um diese Kompensation ausführen zu können, werden die k bits, die am signifikantesten sind (mit k ≤ m) des Phasenregisters 92, das auch den sägezahnförmigen Phasenfehler auf Leitung 96 repräsentiert (mit einer Genauigkeit ( $1-2^{-k}$)) wie es in der Zeitfunktion 99 des sägezahnförmigen Phasenfehlers dargestellt ist, subtrahiert von dem Signal auf Leitung 78 in einer Subtraktionsschaltung 98. Wenn k = 4 ist, ist die Genauigkeit der Subtraktion etwa 0,94. Bei k = 8 ist sie etwa 0,996 usw. Eine sägezahnförmige Phasenfehlerkurve 100 ist in Fig. 7 dargestellt so wie sie auf Leitung 81 erscheint, d.h. die Differenz zwischen dem Signal auf Leitung 78 und dem Signal auf Leitung 96. Das reduziert dann den Phasenfehler auf Leitung 81 zu

$$\phi_e = \frac{T_{OUT}}{2^k}$$

, der dann weiter durch das Schleifenfilter 82 gefiltert wird.

Wenn beispielsweise die Festfrequenz 10 MHz beträgt und die oberen 8 bit des Phasenregisters in der Sägezahn-Phasenkompensationsschaltung verwendet werden, so ist der resultierende Phasenfehler auf der Leitung 81

$$\frac{100ns}{2^8} = 0,4ns.$$

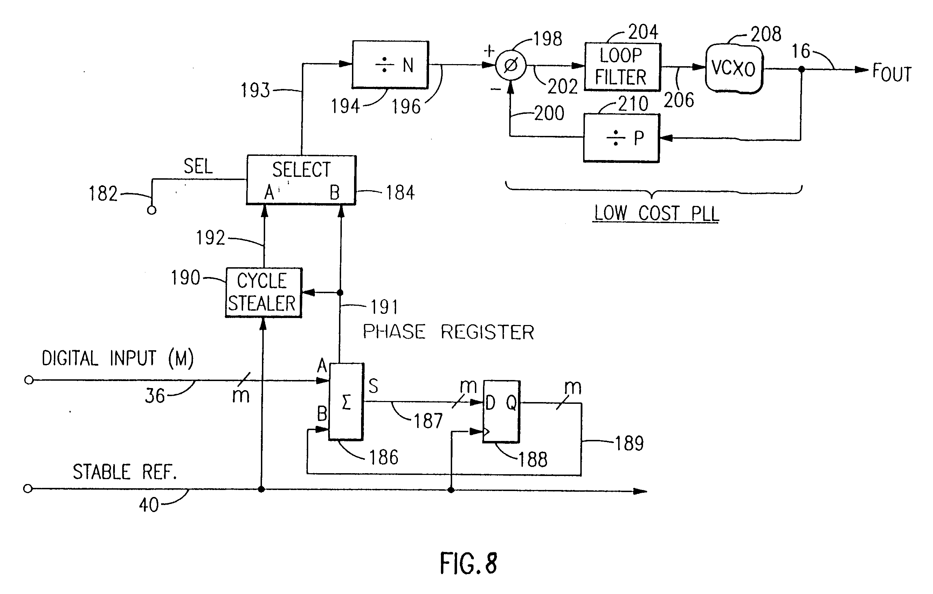

Fig. 8 zeigt eine weitere Variante des Frequenzsynthesizers 38 wie er in Fig. 6 dargestellt ist. Gemäß Fig. 8 besteht ein Phasenregister aus einer Summierschaltung 186 und einem Register 188, die beide eine Auflösung von m-bit haben. Ein Rückkopplungssignal auf Leitung 189 wird der Summierschaltung 186 zugeführt, um den letzten Summenwert an den Eingang B der Summierschaltung 186 rückzukoppeln. Der digitale Eingang auf Leitung 36 addiert den Wert M bei jeder Periode der Festfrequenz. Eine Impulsausblendschaltung 190 wird sowohl von der Festfrequenz auf Leitung 40 als auch von dem carry-Signal auf Leitung 191, herrührend von der Summierschaltung 186, angesteuert. Das carry-Signal blendet einen Impuls der Festfrequenz aus, wenn die Summierschaltung überläuft. In Abhängigkeit von der Größe des Auswahlsignals auf Leitung 182 stellt die Auswahlschaltung 184 entweder das Signal auf Leitung 192 oder das Signal auf Leitung 191 als Ausgangssignal auf Leitung 193 für den Teiler 194 zur Verfügung. Ein geteiltes Signal gelangt dann auf Leitung 196 zur einer kostengünstigen PLL-Schaltung, die einen Phasendetektor 198 enthält, der von dem Signal auf Leitung 196 und einem Rückkopplungssignal auf Leitung 200 angesteuert wird und ein Fehlersignal auf Leitung 202 für das Schleifenfilter 204 liefert. Dieses beseitigt den Hochfrequenzjitter und das Ausgangssignal gelangt auf Leitung 206 zu einem spannungsgesteuerten Oszillator 208, der wiederum das Ausgangssignal auf Leitung 16 für einen internen Takt und für einen Teiler 210 liefert.

Mit der erfindungsgemäßen Schaltungsanordnung lassen sich mit dem gleichen thermostatstabilisierten Festfrequenzgenerator Taktgeneratoren mit unterschiedlichen Frequenzen realisieren. Durch diese universelle Einsatzmöglichkeit sind derartige regelbare Oszillatoren in großen Stückzahlen und damit kostengünstig herstellbar. Dadurch, daß Festfrequenzgeneratoren anstelle von spannungsgesteuerten Oszillatoren verwendet werden, wird eine bessere Kurzzeitstabilität, eine geringere Alterungsrate und eine bessere Temperaturstabilität erzielt. Außerdem wird mit der erfindungsgemäßen Schaltungsanordnung ein wesentlich größerer Frequenzregelbereich, auch Ziehbereich genannt, erreicht. Die Schaltungsanordnung ist ausschließlich mit Baugruppen, deren Versorgungsspannung U = + 5V beträgt, realisierbar und ist problemlos in üblichen Nachrichtenübertragungsanlagen einsetzbar.

**Patentansprüche**

1. Schaltungsanordnung für einen regelbaren Oszillator, **dadurch gekennzeichnet,** daß ein Festfrequenzgenerator (1) mit einem Frequenzteiler (2) dessen Teilerverhältnis einstellbar ist, verbunden ist, und daß der Ausgang des Frequenzteilers (2) an einen Eingang des Phasendetektors eines analogen Phasenregelkreises (3) geschaltet ist.

2. Schaltungsanordnung nach Anspruch 1, dadurch gekennzeichnet, daß der Frequenzteiler (2) aus einem Register besteht, dessen Ausgang an den ersten Eingang eines Addierers (Adder) geschaltet ist, daß der zweite Eingang des Addierers (Adder) mit einem Mikroprozessor (OBC) verbunden ist und daß der Ausgang des Addierers (Adder) an den Sollfrequenzeingang des Phasendetektors des analogen Phasenregelkreises (3) geschaltet ist.

3. Schaltungsanordnung nach Anspruch 2, dadurch gekennzeichnet, daß der Addierer (Adder) an den ersten Eingang einer Impulsausblendschaltung (Cycle Stealing) geschaltet ist, daß der zweite Eingang der Impulsausblendschaltung (Cycle Stealing) mit dem Ausgang des Festfrequenzgenerators (1) verbunden ist und der Impulsausblendschaltung (Cycle Stealing) ein Frequenzteiler mit festem Teilerverhältnis nachgeschaltet ist.

4. Schaltungsanordnung nach Anspruch 1, dadurch gekennzeichnet, daß der Festfrequenzgenerator (1) einerseits über einen Frequenzteiler mit festem Teilerverhältnis mit dem Register verbunden ist und andererseits über eine erste Impulsausblendschaltung (Cycle Stealing 1) die die Differenz zwischen Frequenz des Festfrequenzgenerators (1) und Frequenz der Ausgangsimpulse des Addierers (Adder) bildet, mit nachgeschaltetem Frequenzteiler an den Sollfrequenzeingang des Phasendetektors des analogen Phasenregelkreises (3) geschaltet ist und daß der Ausgang des Addierers (Adder) über eine zweite Impulsausblendschaltung (Cycle Stealing 2), die die Differenz der Frequenz der Ausgangsimpulse des Addierers (Adder) und der Ausgangsfrequenz des analogen Phasenregelkreises (3) bildet, mit nachgeschaltetem Frequenzteiler mit dem Vergleichsfrequenzeingang des Phasendetektors des analogen Phasenregelkreises (3) verbunden ist.

5. Schaltungsanordnung nach Anspruch 1, dadurch gekennzeichnet, daß der Festfrequenzgenerator (1) über einen Frequenzteiler mit dem Sollfrequenzeingang des Phasendetektors des analogen Phasenregelkreises (3) verbunden ist, daß der Eingang des Frequenzteilers (2) mit einstellbarem Teilerverhältnis an den Ausgang des analogen Phasenregelkreises (3) und der Ausgang des Frequenzteilers (2) mit einstellbarem Teilerverhältnis an den Vergleichsfrequenzeingang des Phasendetektors des analogen Phasenregelkreises (3) geschaltet ist.

6. Verfahren zur Erzeugung eines synchronisierten Taktes, dadurch gekennzeichnet,
   - daß eine Phase eines digitalen Eingangssignals (12) mit einer Phase des Ausgangssignals (16) der analogen PLL-Schaltung (3) in einem Phasendetektor (14) verglichen wird,
   - daß aus dem Vergleich ein Fehlersignal (18) abgeleitet wird, daß das Fehlersignal (18) mit einem Schleifenfilter (20) gefiltert wird,
   - daß von einem Festfrequenzgenerator (1) ein Festfrequenzsignal (40) geliefert wird und
   - daß von einem digitalen Frequenzsynthesizer (38) das Ausgangssignal (16) der analogen PLL-Schaltung (3) in Abhängigkeit von dem gefilterten Fehlersignal (36) und dem Festfrequenzsignal erzeugt wird.

7. Verfahren nach Anspruch 6, dadurch gekennzeichnet,
   - daß das Ausgangssignal (16) der analogen PLL-Schaltung (3) mittels eines Frequenzteilers (17) geteilt wird und
   - daß somit ein geteiltes Ausgangssignal (15) der analogen PLL-Schaltung (3) zum Vergleich mit dem digitalen Eingangssignal geliefert wird.

**8.** Verfahren nach Anspruch 6, dadurch gekennzeichnet, daß in dem digitalen Frequenzsynthesizer (38) folgende Verfahrensschritte durchgeführt werden:
- Vergleich (74) der Phase des Festfrequenzsignals (40) mit der Phase eines zweiten rückgekoppelten Signals (76), um ein zweites Phasenfehlersignal (78) zu erhalten,
- Vergleich (98) des zweiten Phasenfehlersignals (78) mit dem Ausgangssignal (96) eines Phasenakkumulators (92), um ein verringertes Phasenfehlersignal (81) zu erhalten,
- Filtern (82) des verringerten Phasenfehlersignals (81), um dann ein drittes Phasenfehlersignal (83) zu erhalten,
- Erzeugen des Ausgangssignals (16) der analogen PLL-Schaltung (84) mit einer Frequenz, die im Verhältnis des dritten Phasenfehlersignals (81) geändert wird,
- Teilen (86) des Ausgangssignals (16) der analogen PLL-Schaltung (84) durch N oder durch N + 1 in Abhängigkeit von einem carry-Signal (88), um das zweite rückgekoppelte Signal zu erhalten,
- Summieren (90) des gefilterten Fehlersignals (36) mit dem Ausgangssignal (96) des Phasenakkumulators (92), um ein Summensignal (94) und das carry-Signal (88) zu erzeugen und
- Speichern (92) des Summensignals (94) in Abhängigkeit vom Ausgangssignal (16) der analogen PLL-Schaltung (3), um das Ausgangssignal (96) des Phasenakkumulators (92) zu erzeugen.

**9.** Verfahren nach Anspruch 6, dadurch gekennzeichnet, daß in dem digitalen Frequenzsynthesizer (38) folgende Verfahrensschritte durchgeführt werden:
- Summieren (186) des gefilterten Fehlersignals (36) mit einem Ausgangssignal (189) eines Phasenakkumulators, um ein Summensignal (187) und ein carry-Signal (191) zu erzeugen,
- Speichern (188) des Summensignals (187), um das Ausgangssignal (189) des Phasenakkumulators in Abhängigkeit von dem Festfrequenzsignal (40) zu erzeugen,
- Ausblenden eines Impulses (190) im Festfrequenzsignal (40) in Abhängigkeit von dem carry-Signal (191), um ein mit Lücken versehenes Festfrequenzsignal (192) zu erhalten,
- Wahl (184) entweder des mit Lücken versehenen Festfrequenzsignals (192) oder des carry-Signals (191) in Abhängigkeit von einem Auswahlsignal (182), um das mit Lücken versehene Festfrequenzsignal (192) oder das carry-Signal (191) zu erhalten, das dann geteilt (194) wird, um dann ein geteiltes Signal (196) mit überlagertem Phasenjitter zu erhalten,
- Vergleich (198) des geteilten Signals (196) und eines geteilten Ausgangssignals (200), um ein zweites Fehlersignal (202) zu erhalten,
- Filtern (204) des zweiten Fehlersignals (202), um ein gefiltertes zweites Fehlersignal (206) zu erhalten,
- Bilden (208) des Ausgangssignals (16) der analogen PLL-Schaltung (3) mit einer Frequenz entsprechend der Größe des gefilterten zweiten Fehlersignals (206) und
- Teilen (210) des Ausgangssignals (16), um ein geteiltes Rückkopplungssignal (200) zu erhalten.

Fig. 1

Fig. 2

Fig. 3

Fig. 4

Fig.5

FIG. 6

FIG.7

FIG.8

EP 0 630 129 A2